# EUROPÄISCHE PATENTSCHRIFT

(11) **EP 0 541 756 B1**
(45) Veröffentlichungstag und Bekanntmachung des Hinweises auf die Patenterteilung: **19.11.1997**
(21) Anmeldenummer: 92911051.8
(22) Anmeldetag: 29.05.1992
(51) Int. Cl.: H01L 27/22, H01L 27/092

(54) **MONOLITHISCH INTEGRIERTER SENSORSCHALTKREIS IN CMOS-TECHNIK**
SOLID STATE SENSOR CIRCUIT USING CMOS TECHNOLOGY
CIRCUIT POUR CAPTEUR, A SEMICONDUCTEURS ET FABRIQUE SELON LA TECHNIQUE CMOS

(30) Priorität: 04.06.1991 DE 4118255
(43) Veröffentlichungstag der Anmeldung: 19.05.1993
(73) Patentinhaber: Deutsche ITT Industries GmbH, 79108 Freiburg (DE)
(72) Erfinder: BLOSSFELD, Lothar, D-7800 Freiburg i. Br. (DE)
(86) Internationale Anmeldenummer: EP9201196
(87) Internationale Veröffentlichungsnummer: WO9222093

(56) Entgegenhaltungen:
- US-A- 4 780 625
- IEEE JOURNAL OF SOLID-STATE CIRCUITS. Bd. 23, Nr. 5, Oktober 1988, NEW YORK US Seiten 1224 - 1232; GABARA T.: 'Reduced Ground Bounce and Improved Latch-Up Suppression Through Substrate Conduction'
- PATENT ABSTRACTS OF JAPAN vol. 7, no. 272 (E-214)(1417) 3. Dezember 1983 & JP-A-58 154 263
- PATENT ABSTRACTS OF JAPAN vol. 7, no. 162 (E-187)(1307) 15. Juli 1983 & JP-A-58 070 564
- IEEE ELECTRO Bd. 7, Mai 1982, LOS ANGELES US Seiten 1 - 12; NELSON R,W.: 'INTEGRATED HALL SENSORS'

## Beschreibung

Die Erfindung betrifft einen monolithisch integrierten Sensor mit Sensorschaltkreis in CMOS-Technik.

Sensoren, die Fühlerelemente der Mikroelektronik, sind letztlich Meßwertaufnehmer, die eine Rückmeldung über Zustandsänderungen technischer Systeme ermöglichen. Als Bindeglieder zwischen der analogen Welt von Temperatur, Druck, Beschleunigung usw. sowie anderen physikalischen Variablen mit der digitalen Welt der Prozessoren entscheiden sie maßgeblich über die Reaktionsschnelligkeit der Elektronik mit. Sensoren benötigen normalerweise eine elektronische Schaltung zur Auswertung der Signalspannungen. Da die Sensoren, wie z.B. ein Hall-Generator, nur Spannungen von wenigen mV oder uV abgeben, sind Verstärkerschaltungen notwendig. Diese werden üblicherweise in Bipolartechnik realisiert, da sie gegenüber der MOS-Technik überlegene analoge Eigenschaften besitzt. Insbesondere bei höheren Temperaturen ergeben sich beim Einsatz der CMOS-Technik erhebliche Probleme z.B. bezüglich der latch-up Immunität. Um "intelligentere" Sensoren herstellen zu können, ist jedoch eine Integration des Sensors zusammen mit einer digitalen Technologie wünschenswert.

Aus der Druckschrift T. Garbara, IEEE J. of Solid-State Circuits, Bd. 23, Nr. 5, Oktober 1988, New York, S.1224-1232" ist eine auf einem Halbleiterchip integrierte Schaltung in CMOS-Technik offenbart, wobei die Schaltung über das Substrat am Masseanschluß liegt und die Spannungssignale für den Eingang der Schaltung nicht auf dieses Potential bezogen sind.

Der Erfindung liegt die Aufgabe zugrunde, einen Sensor in CMOS-Technologie zu schaffen, der für einen erweiterten Temperaturbereich von -150 bis 190°C verwendet werden kann.

Diese Aufgabe wird durch einen Sensor mit den Merkmalen des Patentanspruchs 1 gelöst.

Bevorzugte Ausführungsbeispiele sind in den Unteransprüchen offenbart.

Der Grundgedanke derselben besteht dabei darin, den infolge hoher Temperaturen bei einer CMOS-Schaltung auftretenden latch-up dadurch zu vermeiden, daß die negative Batteriespannung über die Rückseite des Substrats zugeführt wird, das heißt also das Substrat direkt auf Masse zu legen, so daß zwischen dem Masseanschluß der Schaltung und der negativen Batteriespannung der Substratwiderstand liegt. Der an ihm auftretende Spannungsabfall macht ein Zünden von parasitären Vierschichtelementen unmöglich.

Ein weiterer Vorteil besteht darin, daß bei den heute angestrebten kleine Chipgrößen die sonst üblicherweise für den Masseanschluß benötigte Fläche auf der Oberseite für aktive Bauelemente zur Verfügung steht. Am Substratwiderstand treten jedoch Schaltimpulse oder Schaltströme auf, die auf die Eingänge rückwirken. Die angeführte Lösung ist deshalb nur in Verbindung mit Eingangssignalen möglich, die nicht auf das Potential des Masseanschlusses bezogen sind. Derartige Signalquellen stellen die meisten Sensoren, wie z.B. Hall-Sensoren dar.

Weiterhin sind Rückwirkungen der Leitungsausgänge direkt über das Substrat möglich. Um dies zu vermeiden, ist eine Trennung der Masseleitungen von analogen und digitalen Schaltungsteilen erforderlich. Um den Substratwiderstand einzustellen, z.B. möglichst klein zu machen, kann ein niederohmiges Substrat mit einer dünnen hochohmigen Epitaxischicht eingesetzt werden. Der an der Kante des Chips vorhandene Ritzgrabenrest kann flächensparend zur Massekontaktierung herangezogen werden, wenn bestimmte Schaltungsbereiche getrennt von den übrigen an Masse gelegt werden sollen.

Zum Schutz gegen allfällige statische Entladungen werden Schutzstrukturen wie z.B. PN-Zenerdioden oder Substrat-PNP-Transistoren angebracht, die in diesem Fall nicht mit einer auf dem Chip befindliche Metalleitung verbunden sind, sondern zwischen den Bondpads bzw. der Versorgungsleitung und dem Masseanschluß liegen.

Durch Gehäuse, Druck und Temperatureinfluß entstehen Widerstandsänderungen und Leckströme, die erheblich die Funktion analoger Schaltungen oder Sensoren stören können. Um einen erweiterten Temperaturbereich ausnützen zu können, müssen deshalb die Sensoren achsensymmetrisch angeordnet und gegen vom Gehäuse ausgeübten Diagonalstreß geschützt, das heißt kompensiert sein. Im Falle z.B. eines Hallgenerators ist die günstigste Anordnung für ihn in der Chipmitte. Gleiche Anforderungen sind an die Eingangsstufen von Verstärkern zu stellen. Metall- oder Polysiliziumleitungen können ebenfalls in Verbindung mit einem Plastikgehäuse Druck auf die Oberfläche des Chips ausüben, was zur Fehlfunktion des Sensors führen kann. Eine Kreuzung solcher Leitungsbahnen über Eingangstransistoren oder Sensoren ist deshalb zu vermeiden, was durch eine symmetrische Anordnung derselben möglich ist.

Die Erfindung wird nunmehr nachstehend anhand der einzelnen Figuren näher erläutert.
Fig. 1 zeigt die schematische Schrägansicht eines Halbleiterchips, das auf den entsprechenden Teilen eines Trägerbandes angeordnet und gebondet ist.
Fig. 2 zeigt das zugehörige Ersatzschaltbild,
Fig. 3 zeigt die Trennung der Masseleitungen der einzelnen Schaltungsteile,
Fig. 4 zeigt das Ersatzschaltbild nach Fig. 2 mit eingefügten Schutzstrukturen,
Fig. 5 zeigt die Realisierung einer Schutzstruktur,
Fig. 6a zeigt die zur Streßvermeidung erforderliche Anordnung der externen Signalquellen, und
Fig. 6b zeigt die entsprechende symmetrische Anordnung eines Hallgenerators.

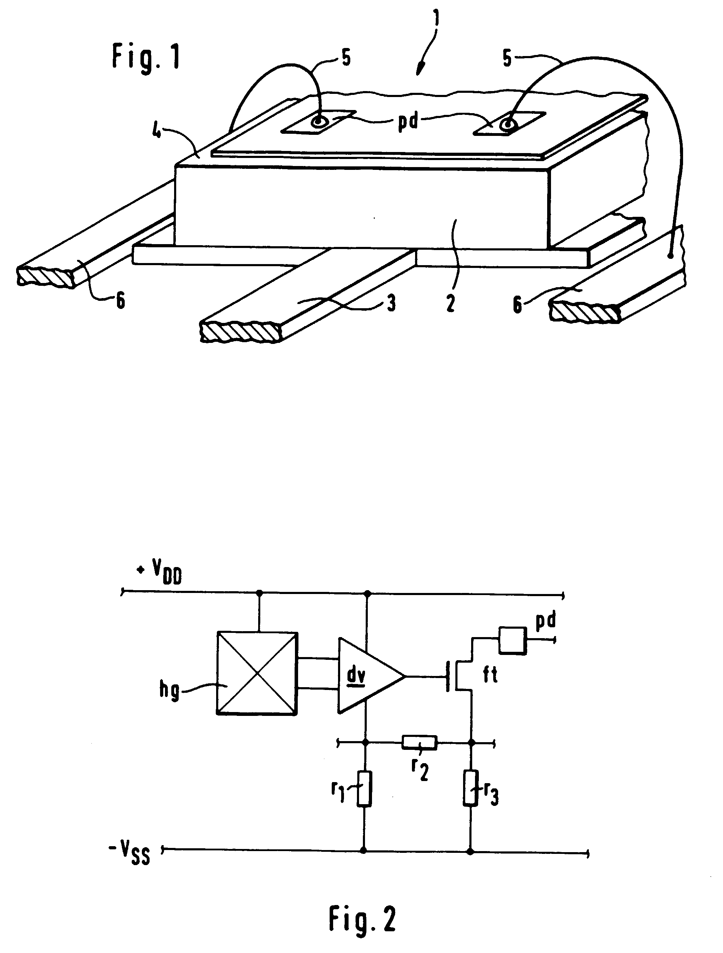

Fig. 1 zeigt schematisch das Halbleiterchip 1, das mit seiner Substratrückseite auf dem Masseanschluß 3 leitend befestigt ist und dessen Bondpads pd über Bonddrähte 5 mit den Anschlußstreifen 6 verbunden sind. Die auf dem Substrat 2 realisierte Schaltung ist aus Übersichtsgründen nicht eingezeichnet. Man erkennt ferner den an der Chipkante noch verbliebene Rest des Ritzgrabens 4, der dazu benutzt werden kann, isolierte Schaltungsteile an Masse zu legen, so daß auf diese Weise auf der Oberfläche des Chips Platz gespart wird.

Fig. 2 zeigt das Ersatzschaltbild der Anordnung nach Fig. 1. Die Ausgänge des an der Versorgungsspannung vdd liegenden Hallgenerators hg führen in den Differenzverstärker dv, dessen Ausgang am Gate des Feldeffekttransistors ft liegt, dessen Drain-Source-Strecke vom Bondpad pd über den Widerstand r3 zur Masse VSS führt. Vom Verbindungspunkt der Source-Elektrode mit dem Widerstand r3 führt der Widerstand r2 zum Steuereingang des Differenzverstärkers dv, der wiederum über den Widerstand r1 an Masse liegt. Der Widerstandswert der Widerstände r1 bzw. r2 ist dabei so einzustellen, daß sie der Bedingung r2 >> r1 bzw. r3 entsprechen, um eine Querverbindung zu unterbinden.

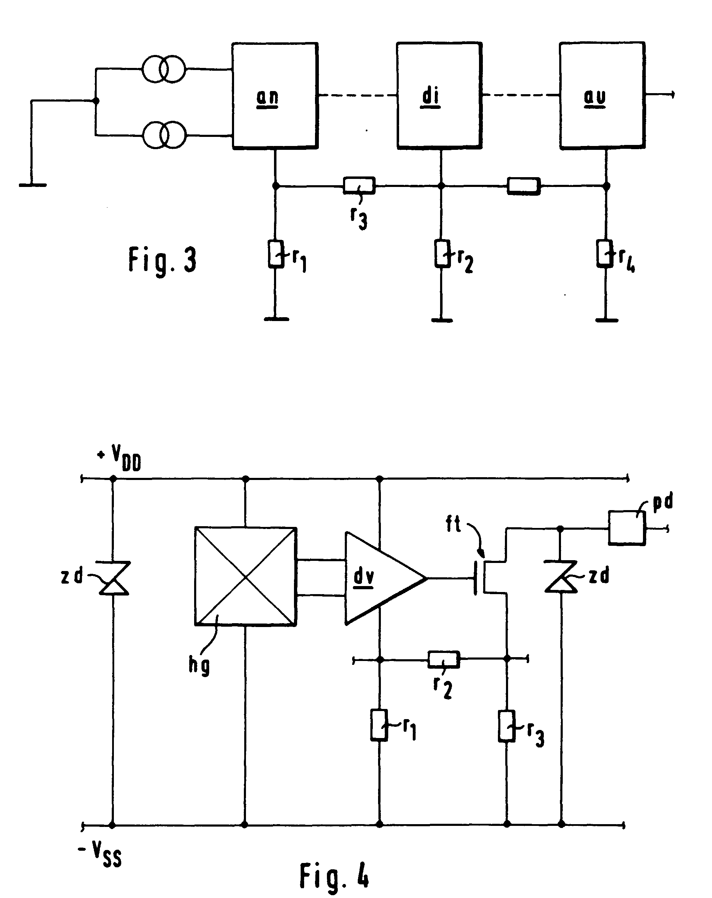

Die Fig. 3 zeigt das generelle Prinzip der Beispielschaltung nach Fig. 2. Man erkennt die beiden symmetrischen Signalquellen von denen die Signale in den Analogteil an führen. An diesen schließt sich der Digitalteil di und daran die Ausgangsstufe au an. Für die gezeigten Widerstände gilt das gleiche wie in Fig. 2, das heißt Widerstand r1 und r3 sind jeweils kleiner als Widerstand r2 bzw. Widerstand r3 und Widerstand r4 jeweils kleiner als Widerstand r2'.

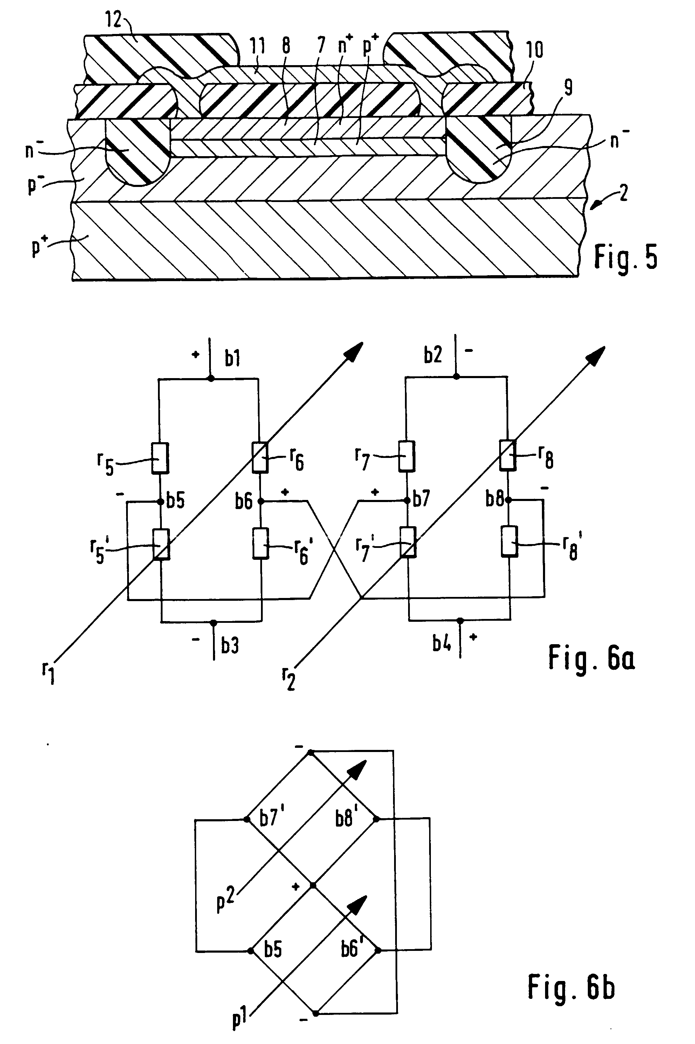

Fig. 4 entspricht der Fig. 3 mit Ausnahme der zusätzlichen beiden Schutzstrukturen (Schutzdioden zd), die zwischen der Versorgungsleitung Vdd bzw. dem Anschlußpad pd einerseits und dem Masseanschluß Vₛₛ bzw. den Anschlußpad pd und dem Masseanschluß Vss andererseits angeordnet sind.

Fig. 5 veranschaulicht beispielhaft den Schnitt durch die Struktur einer derartigen Schutzdiode zd. Das p-dotierte Substrat 2 ist auf seiner Unterseite zur Herabsetzung des Kontaktwiderstandes hochdotiert (p⁺). Von der Oberseite des Substrats 2 ist in dieses eine hochdotierte Schicht 7 vom gleichen Leitungstyp wie das Substrat 2 selbst und anschließend eine hochdotierte Schicht 8 vom entgegengesetzten Leitungstyp derselben eingelassen. Diese beiden Schichten 7, 8 sind von einer schwach dotierten n-leitenden Isolierzone 9 umgeben. Auf der Oberfläche des Substrats ist zunächst eine Isolierschicht 10 aufgebracht, in der Kontaktlöcher für die Aluminiumverdrahtung 11 angeordnet sind, die zu der Schicht 8 führen. Eine zweite Isolierschicht 12 ist in üblicher Weise über die Verdrahtung gelegt.

Fig. 6a zeigt die Streßkompensation anhand zweier symmetrischer Signalquellen, die aus jeweils vier gleichartigen Widerständen in Form von Brückenschaltungen aufgebaut sind. Linien gleichen Drucks werden durch die Pfeile r1 und r2 angezeigt. Unter der Annahme, daß der Druck den Widerstandswert verringert, wird der Widerstand in r5 kleiner und damit der Brückenpunkt b5 negativ geladen, während umgekehrt der Brückenpunkt b6 auf positiv hochgezogen wird. Bei entsprechender umgekehrter Polung in der rechten Brückenschaltung, das heißt negative Polung an Brückenpunkt b2, positive Polung an Brückenpunkt b4, tritt der umgekehrte Effekt ein. Zur Kompensation sind deshalb die Brückenpunkte 5 mit 7 und 6 mit 8 zu verbinden.

Die Fig. 6b veranschaulicht die streßkompensierte Anordnung eines Sensors, z.B. eines Hallgenerators, wobei der obere Teil der rechten Brücke und der untere Teil der linken Brücke in Bild 4 entspricht. Durch die Verbindung der Brückenpunkte 5' und 7' bzw. 6' und 8' wird der Stress kompensiert, der wie mit den Pfeilen angedeutet, den Brückenabgleich stört.

## Patentansprüche

1. Monolithisch integrierter Hall-Sensor (hg) mit Sensorschaltung in CMOS-Technik, bei dem die auf dem Halbleiterchip (1) realisierte Schaltung über dessen Substrat (2) am Masseanschluß (3) liegt, wobei der Hall-Sensor zur Erzeugung von Eingangssignalen vorgesehen ist, die nicht auf das Potential des Masseanschlusses (3) bezogen sind.

2. Sensorschaltung nach Anspruch 1, dadurch gekennzeichnet, daß die Masseleitung von analogen (an) und digitalen (di) Schaltungsteilen voneinander getrennt sind.

3. Sensorschaltung nach einem der vorhergehenden Ansprüche, dadurch gekennzeichnet, daß Schutzstrukturen zwischen Anschlußpads (pd), die zum Anschluß eines zwischen dem Masseanschluß und der Versorgungsleitung liegenden Potentiais an die integrierte Schaltung auf dem Halbleiterchip (1) vorgesehen sind, bzw. der Versorgungsleitung (VDD) und dem Masseanschluß (Vss) liegen.

4. Sensorschaltung nach den vorhergehenden Ansprüchen, dadurch gekennzeichnet, daß auf dem Halbleiterchip (1) Sensorelemente und mit diesen verbundene Eingangsstufen integrierter Verstärker achsensymmetrisch zu einer Längsachse des Halbleiterchips (1) angeordnet sind und mit einer kreuzweisen Anordnung von Metall- oder Polysiliziumleitungen verschaltet sind, welche achsensymmetrisch zu der Längsachse ist.

5. Sensorschaltung nach einem der vorhergehenden Ansprüche, dadurch gekennzeichnet, daß ein an der Chipkante liegende Ritzgraben (4) zur Kontaktierung von Schaltungsteilen verwendet wird.

## Claims

1. A monolithic integrated Hall sensor (hg) with a sensor circuit in CMOS technology wherein the circuit, which is implemented on the semiconductor chip (1), is connected to the ground connection (3) via the substrate (2) of the semiconductor chip (1), the Hall sensor being provided for generating input signals which are not referred to the potential of the ground connection (3).

2. A sensor circuit as claimed in claim 1, characterized in that the ground leads of analog (an) and digital (di) subcircuits are separated from each other.

3. A sensor circuit as claimed in either of the preceding claims, characterized in that protective stuctures are provided between bonding pads (pd), via which a potential between the ground connection and the supply line can be connected to the integrated circuit on the semiconductor chip (1), and the ground connection (V_{SS}) and between the supply line (V_{DD}) and the ground connection (V_{SS}).

4. A sensor circuit as claimed in any one of the preceding claims, characterized in that sensing elements and integrated amplifier input stages connected thereto are arranged on the semiconductor chip (1) symmetrically with respect to a longitudinal axis of the semiconductor chip (1) and are interconnected with a crossed arrangement of metal or polysilicon lines which is symmetrical with respect to the longitudinal axis.

5. A sensor circuit as claimed in any one of the preceding claims, characterized in that a scribe line (4) located at the chip edge is used to make contact to subcircuits.

## Revendications

1. Capteur intégré monolithique à effet Hall (hg) comportant un circuit pour capteur réalisé selon la technique CMOS, dans lequel le circuit réalisé sur la puce à semi-conducteurs (1) est mis à la borne de masse (3) par l'intermédiaire de son substrat (2), le capteur à effet Hall étant prévu pour la production de signaux d'entrée qui ne sont fixés par rapport au potentiel de la borne de masse (3).

2. Circuit pour capteur selon la revendication 1, caractérisé en ce que les conducteurs de masse des parties analogique (an) et numérique (di) du circuit sont séparées l'une de l'autre

3. Circuit pour capteur selon l'une quelconque des revendications précédentes, caractérisé en ce que des structures de protection se trouvent entre des plages de connexion (pd), qui sont prévues pour la connexion d'un potentiel se trouvant entre la borne de masse et le conducteur d'alimentation au circuit intégré se trouvant sur la puce à semi-conducteurs (1), ou le conducteur d'alimentation (V_{DD}) et la borne de masse (V_{SS}).

4. Circuit pour capteur selon l'une quelconque des revendications précédentes, caractérisé en ce que, sur la puce à semi-conducteurs (1) des éléments de capteur ainsi que des étages d'entrée, reliés à ces derniers, d'amplificateurs intégrés sont disposés avec une symétrie axiale par rapport à un axe longitudinal de la puce à semi-conducteurs (1) et sont branchés avec une disposition croisée de conducteurs en métal ou en polysilicium qui présente une symétrie axiale par rapport à l'axe longitudinal.

5. Circuit pour capteur selon l'une quelconque des revendications précédentes, caractérisé en ce qu'une tranchée de fente (4) se trouvant sur l'arête de la puce est utilisée pour la mise en contact de parties du circuit.
